Europäisches Patentamt

(19) European Patent Office

Office européen des brevets

(11) Publication number: **0 103 362**
**B1**

(12) **EUROPEAN PATENT SPECIFICATION**

(45) Date of publication of patent specification: **30.03.88**

(21) Application number: **83303768.2**

(22) Date of filing: **29.06.83**

(51) Int. Cl.⁴: **H 01 L 23/52**

(54) Semiconductor device with power lines.

(30) Priority: **30.06.82 JP 112995/82**

(43) Date of publication of application:
**21.03.84 Bulletin 84/12**

(45) Publication of the grant of the patent:
**30.03.88 Bulletin 88/13**

(84) Designated Contracting States:
**DE FR GB**

(56) References cited:
**FR-A-2 377 705**
**FR-A-2 426 334**
**GB-A-2 061 617**
**GB-A-2 088 629**
**GB-A-2 089 121**
**US-A-3 981 070**
**US-A-4 278 989**

(73) Proprietor: **FUJITSU LIMITED**
**1015, Kamikodanaka Nakahara-ku**
**Kawasaki-shi Kanagawa 211 (JP)**

(72) Inventor: **Hino, Youzi**
**2607, Suge Tama-ku**
**Kawasaki-shi Kanagawa 214 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

Courier Press, Leamington Spa, England.

## Description

The present invention relates to a semiconductor device, more particularly to power lines distributed on a semiconductor device.

Recent large scale integrated circuits (LSI's) have featured larger scales and larger numbers of pins than ever before. The larger scale of LSI's has necessarily increased the length of each power line and, accordingly, made the resistance of the power line a factor for consideration. The increased number of pins has considerably increased the number of input/output pins.

The increased number of input/output pins in turn necessarily enlarges the scale of the peripheral circuit region, such as the input/output buffer circuits. The enlarged output buffer circuits may often cause generation of an instantaneous large current. Such an instantaneous large current may flow in the power line, when the output logics of a plurality of output buffer circuits to be connected to external bus lines change from "H" (high) to "L" (low), and vice versa, all at once.

The product of the instantaneous large current and the resistance of the power line causes a voltage drop. This results in a deviation in level of a $V_{SS}$ power line, which usually provides, as a ground level, a reference voltage for the whole integrated circuit.

Also, in a transistor transistor logic (TTL) circuit driven by a power source of, for example, 5 V, since the threshold levels for discriminating the logics "H" and "L" are usually 2.4 V and 0.4 V, respectively, although a large margin of (5—2.4) V for the output is obtained at the power source level side (i.e., $V_{DD}$ power line side), the margin for the output is as small as (0.4—0) V at the ground level side (i.e., $V_{SS}$ power line side). Under such conditions, such a voltage drop in the $V_{SS}$ power line may drastically reduce the noise margin, including the margin for each input level at logic "H" side. Similarly, such a voltage drop in the $V_{DD}$ power line may reduce the noise margin, including the margin for each input level at the logic "L" side. This can lead to malfunctions in the LSI circuit.

Thus, in an LSI circuit, the voltage drop in the power lines, i.e., $V_{DD}$ power line and $V_{SS}$ power line, must be made as small as possible. Above all, repression of a voltage drop in the $V_{SS}$ power line is strongly demanded.

In the prior art, two main methods have been proposed for reducing the voltage drop in the power lines. The first is to increase the width of the power lines to lower the resistance of the line. Wide power lines, however, impede high integration of LSI's. Accordingly, a multilayer structure is usually employed in such an LSI circuit. That is, when one of the power lines, for example, the $V_{SS}$ power line, is distributed on a first layer, the other one, e.g., the $V_{DD}$ power line, is distributed on another layer, such as a second layer located thereabove. A multi-layer structure wherein the power lines situated at different levels have different thicknesses is disclosed in US—A—3 981 070.

The second is to intentionally produce a certain delay time in the plurality of outputs from the output pins every time an instantaneous large current is anticipated. Here, the delay time is as short as possible to maintain normal operation of the LSI circuit. In other words, this method, takes an instantaneous large current composed of currents occurring at the same timing and distributes it over time to suppress the overall amplitude of the current to a low level. This method, however, is not suitable for an LSI circuit because it entails the additional provision of a circuit for creating the delay time. Thus, the first method is preferable to the second.

However, the first method itself is not sufficient for future LSI circuits with higher degrees of integration and larger numbers of pins than present LSI circuits.

It is desirable to provide a semiconductor device with power lines which sufficient for future LSI circuits with higher degrees of integration and larger numbers of pins.

The present invention provides a sub-power line in addition to a corresponding original power line, preferably the $V_{SS}$ power line, the power lines being arranged as a multilayer structure with the original and sub-power lines electrically shorted at portions to which at least the output buffer circuits are connected. This makes it possible to halve the inherent resistance of the original power line. Each output buffer circuit is capable of producing a large current.

Thus according to the invention a semiconductor device comprises:

a semiconductor substrate;

a logic circuit region arranged in the semiconductor substrate, said logic circuit region having a plurality of logic circuits;

a peripheral circuit region arranged around said logic circuit region, said peripheral circuit region including a plurality of output buffer circuits;

a first power line and a second power line distributed at least along the peripheral circuit region, said first power line being connected to each of said output buffer circuits; and

a sub-power line distributed on an insulating layer (14, 17) separating it from said first power line;

in which electric shorts are formed between said first power line and said sub-power line via through holes in said insulating layer (14, 17) at each portion of said first power line under which is is connected to one of said output buffer circuits.

Reference will now be made, by way of example, to the accompanying drawings, wherein:

Fig. 1A is a partial cross-sectional view of a first example of a semiconductor device with power lines distributed thereon, embodying the present invention;

Fig. 1B is a partial cross-sectional view of a second example of a formation of power lines, embodying the present invention;

Fig. 2 is a plan view of a semiconductor device, taken along its first layer, taking as an example a case where the device has a cross-section of Fig. 1A;

Fig. 3 illustrates the arrangement of the second layer, in which a sub $V_{ss}$ power line 16 of the present invention is distributed in addition to the original $V_{DD}$ power line 15;

Fig. 4A is an equivalent circuit diagram of circuit lines, and $V_{ss}$ power source in a case where there are no electric shorts in Fig. 3;

Fig. 4B is an equivalent circuit diagram of the circuit lines, and $V_{ss}$ power source in a case where there are electric shorts in Fig. 3;

Fig. 5 is a circuit diagram of one example of a prior art input buffer circuit shown in Fig. 3;

Fig. 6 depicts waveforms for explaining the operation of the circuit shown in Fig. 5; and

Fig. 7 is a graph showing the relationship between the input voltage level and the number of buffer circuits.

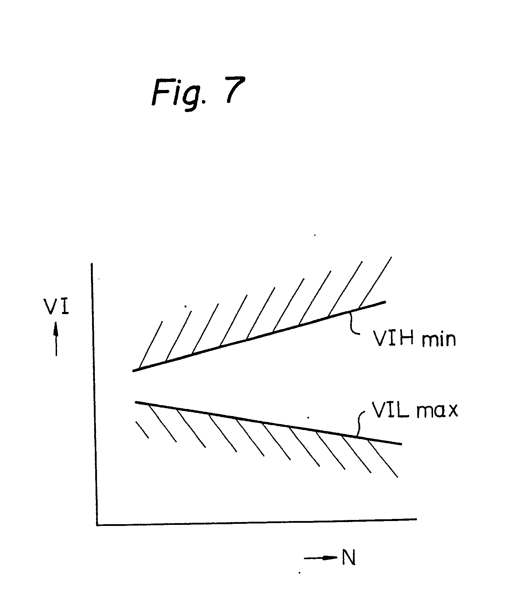

As was previously mentioned, in a transistor transistor logic (TTL) circuit driven by a power source of, for example, 5 V, since the threshold levels for discriminating the logics "H" and "L" are usually 2.4 V and 0.4 V, respectively, although a large margin of (5—2.4) V for the output is obtained at the power source level side (i.e., $V_{DD}$ power line side), the margin for the output is as small as (0.4—0) V at the ground level side (i.e., $V_{ss}$ power line side). Under such conditions, such a voltage drop in the $V_{ss}$ power line may drastically reduce the noise margin, including the margin for each input level at the logic "H" side. Similarly, such a voltage drop in the $V_{DD}$ power line may reduce the noise margin, including the margin for each input level at the logic "L" side. This can lead to malfunctions in the LSI circuit. To be specific, the larger the number (N) of the output and input/output buffer circuits which are driven simultaneously, the lower should the input voltage level VIL of logic "L" be, and the higher should the input voltage level VIH of logic "H" be. This will be clarified with reference to Fig. 7, in which the abscissa indicates the number N of the output and input/output buffer circuits which are driven simultaneously and the ordinate indicates an input voltage level VI supplied externally to the pins of the LSI circuit. In this graph, the hatchings represent areas where a normal operation can be guaranteed. Especially, the lines $VIH_{min}$ and $VIL_{max}$ represent the limits of levels for a minimum input logic level of "H" and a maximum input logic level of "L". This graph shows that, along with an increase of the number N, the areas with hatchings become narrow. This means that, as was mentioned above, the larger the number (N) of the output and input/output buffer circuits which are driven simultaneously, the lower should the input voltage level VIL of logic "L" be and the higher should the input voltage level VIH of logic "H" be.

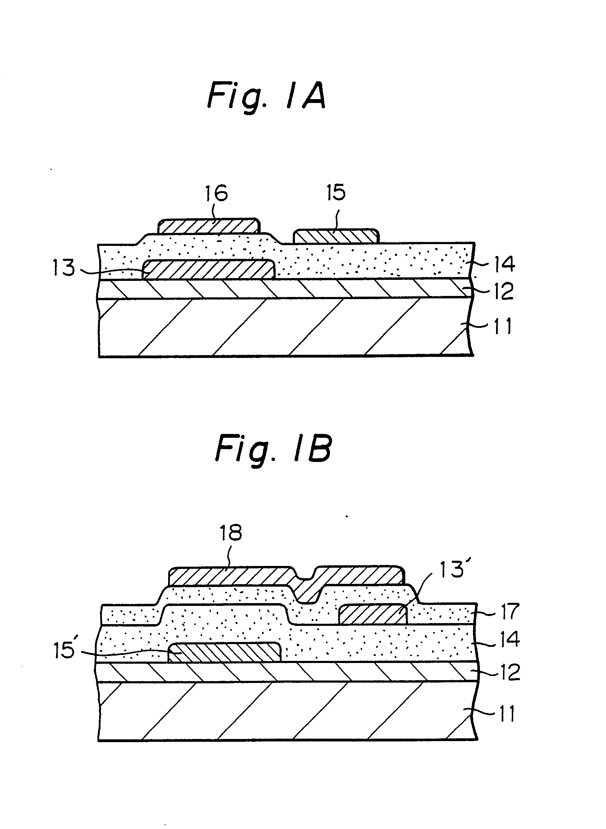

Figure 1A is a partial cross-sectional view of a first example of a semiconductor device with power lines distributed thereon, embodying the present invention. In this figure, reference numeral 11 represents a semiconductor substrate forming a base of a semiconductor chip, and 12 represents a usual insulation film mounted on the substrate 11. On the surface of the insulation film 12, i.e., on a first layer, a $V_{ss}$ power line 13 is mounted. On a second layer (14) of a phosphosilicate glass (PSG) located thereabove a $V_{DD}$ power line 15 is mounted.

The formation of the above layers 13 and 15 is not new, however, attention should be paid to the newly employed sub $V_{ss}$ power line 16 in accordance with the present invention. In this first example, the sub $V_{ss}$ power line 16 is mounted right above the $V_{ss}$ power line 13 and on the second layer on which the $V_{DD}$ power line 15 is also mounted. Generally, the power lines 13 and 15 are shifted in location with each other so as to prevent an electric short therebetween. Thus, the resistance of the $V_{ss}$ power line is substantially halved.

Figure 1B is a partial cross-sectional view of a second example of the formation of power lines, being embodiments of the present invention. The difference in arrangement from Fig. 1A is that, first, a sub $V_{ss}$ power line 18 is mounted on not the second layer but a third layer via a PSG layer 17. Second, a $V_{DD}$ power line 15' and a $V_{ss}$ power line 13' are mounted on the first and second layers, respectively. It is preferable to separate the different power lines, such as 18 and 15', as much as possible, so as to avoid damage due to unintentional shorts therebetween. The same power lines, such as 18 and 13', can be positioned close to each other. An advantage of this second example is that the sub $V_{ss}$ power line 18 can be wider than the sub $V_{ss}$ power line 16 of the first example.

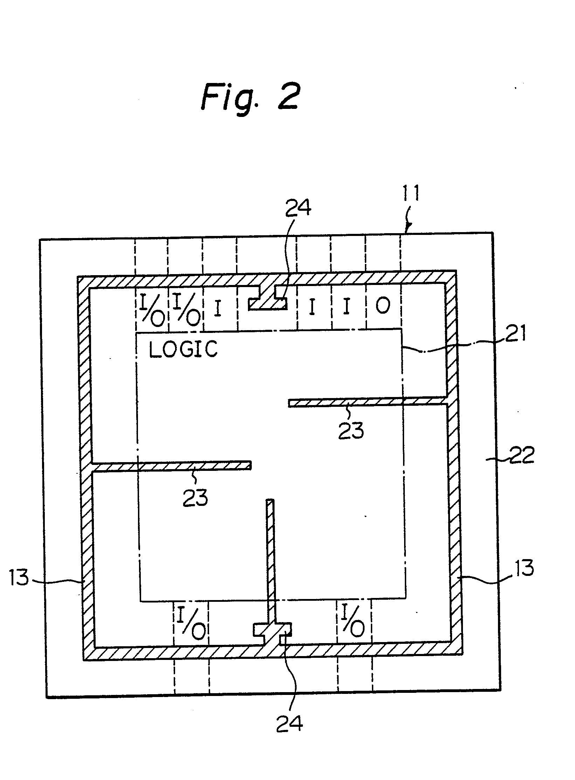

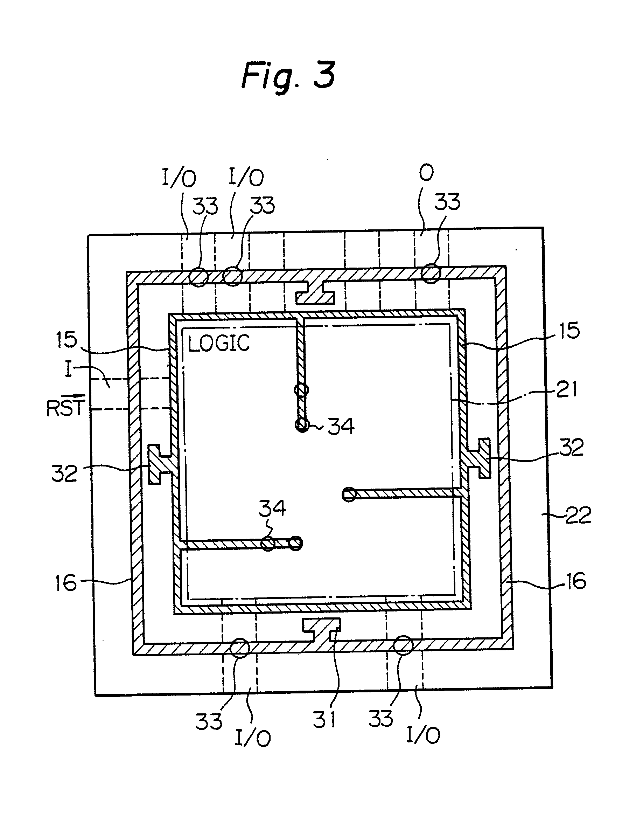

The above explanations were made with reference to partial cross sectional views. The present invention will now further be explained in detail with reference to a plan view. Figure 2 is a plan view of a semiconductor device, taken along its first layer, taking as an example the case where the device has the cross-section of Fig. 1A. Figure 3 is a plan view of a semiconductor device, taken along its second layer, also taking as an example the case where the device has the cross-section of Fig. 1A. Since the second layer is superposed on the first layer, the plan views of these two layers are separated into Figs. 2 and 3 so that the first layer may also be seen.

In Fig. 2, logic circuits (LOGIC) 21 are arranged in the semiconductor substrate 11 at its center (enclosed by chain-dotted lines in this figure). Peripheral circuit region 22 (corresponding to the previously mentioned input/output buffer circuits, referenced in this figure as the symbols I/O, O, or I), is arranged in the substrate at its periphery so as to enclose the logic circuit region 21. Only some of the circuits I/O (input/output), O (out), and I (input) are illustrated for simplicity. Here, the $V_{ss}$ power line 13 is distributed on and along the peripheral circuit region 22, i.e., the periphery of the semiconductor substrate 11. In this figure, the power line is distributed as a closed loop, but it is not limited to this and may be, for example, a closed loop. The $V_{ss}$ power line 13 supplies the power to not only the peripheral circuit region 22, but also to the logic circuit region 21 via branched power lines 23. The power of $V_{ss}$ is externally supplied to the substrate 11 from a pad 24.

Figure 3 illustrates the arrangement of the second layer, in which a sub $V_{ss}$ power line 16 of the present invention is distributed in addition to the original $V_{DD}$ power line 15. These power lines 15 and 16 are distributed on and along the peripheral circuit region 22, i.e., the periphery of the semiconductor substrate 11. In this figure, the power lines 15 and 16 are distributed may be, for example, closed loops, but are not limited to this and, an opened loop. Further, the sub $V_{ss}$ power line 16 is placed almost parallel with the $V_{ss}$ line 13 shown in Fig. 2. Incidentally, a pad 31 is formed as one body with the pad 24 of Fig. 2, and a pad 32 is used for a connection with an external $V_{DD}$ power source via, for example a bonding wire (not shown).

Thus, both $V_{ss}$ power lines 13 and 16 are constructed as a multilayer structure in the area where the peripheral circuit region 22 is positioned. This is because, first the $V_{ss}$ power line 13 is inherently formed in the related area (22) and, second, the reduction of the resistance of the $V_{ss}$ power line is required only for the related area of the peripheral circuit region 22 among all the output buffer circuits (I/O, O) thereof. Thus, to reduce the resistance, it is not sufficient to merely place the sub $V_{ss}$ power line 16 in parallel with the original $V_{ss}$ power line 13. It is further necessary to electrically short these lines 13 and 16 at portions to which at least the output buffer circuits are connected. If not, the desired effect of halving the resistance of the power line cannot be achieved. In Fig. 3, each circle 33 located along the sub $V_{ss}$ power line 16 denotes a portion where the line 16 is electrically shorted to the $V_{ss}$ power line 13 lying thereunder through, for example, a through-hole. It should be understood that the other through-holes 34 are used for supplying the $V_{DD}$ power to the logic circuit region 21.

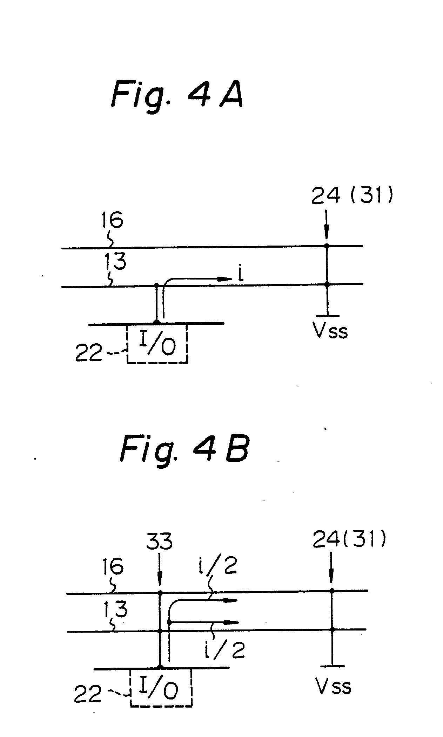

The above mentioned matter will now be explained. Figure 4A is an equivalent circuit diagram of the circuit region 22, the lines 13 and 16, and the $V_{ss}$ power source in a case where there are no electric shorts 33 in Fig. 3. Figure 4B is an equivalent circuit diagram of the circuit region 22, the lines 13 and 16, and the $V_{ss}$ power source in a case where there are electric shorts 33 in Fig. 3.

When there are no electric shorts 33, (refer to Fig. 4A), a current i from the output buffer circuit (symbolized by I/O) flows to the $V_{ss}$ power source only through the $V_{ss}$ power line 13, and exhibits an equivalent resistance of R. Contrary to this, when there are electric shorts 33 between the lines 13 and 16, the current i is divided into two currents i/2 flowing through these lines. Therefore, the equivalent resistance R is reduced to R/2. In these figures, reference numeral 24(31) represents the pads in Figs. 2 and 3 connected with the $V_{ss}$ power source.

It should be noted that while the above explanations are made regarding the power line of the $V_{ss}$ side as the worst case, the same applies to the power line of the $V_{DD}$ side, if necessary. In the worst case, the previously mentioned malfunctions may take place in the LSI circuit.

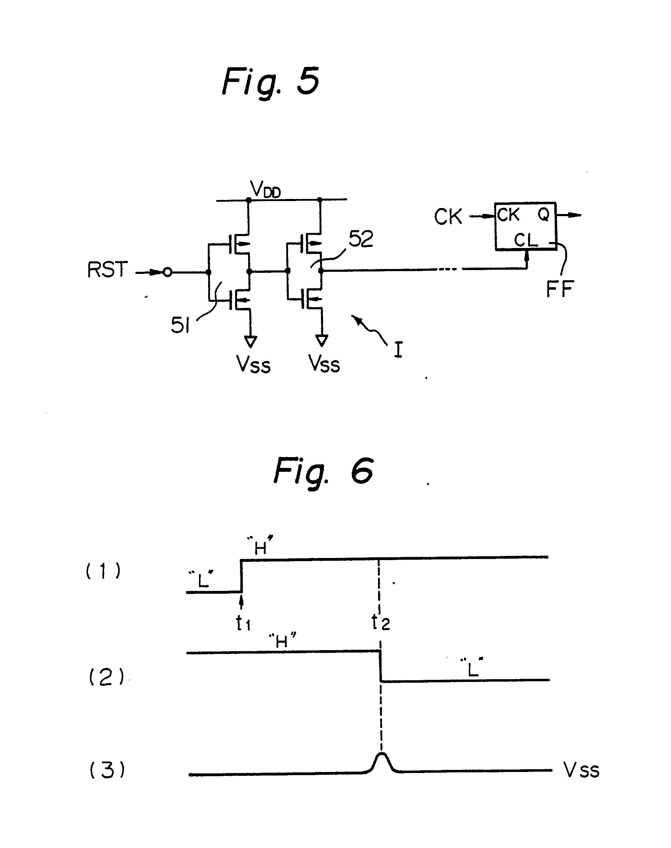

Last, an example of the malfunction will be mentioned for reference. Assuming that the LSI circuit shown in Figs. 2 and 3 is fabricated as a microcomputer unit, a malfunction may take place in conjunction with an asynchronous reset signal RST (only shown in Fig. 3), which is received at certain input buffer circuit I, which signal initializes the operation thereof. Figure 5 is a circuit diagram of an example of a prior art input buffer circuit I shown in Fig. 3. The input buffer circuit I is comprised of an input stage buffer 51 and an inverter 52. The output from the circuit I is supplied to a specified circuit of the logic circuit region 21, for example, a flip-flop FF. In both the buffer 51 and inverter 52, the transistors at the upper side are p-channel types and the transistors at the lower side are n-channel types. The buffer 51 functions as a TTL compatible circuit and determines the input logic "H" or "L" in accordance with the voltage level of the reset signal RST, i.e., whether the level is higher than 2 V or lower than 0.4 V, respectively. When the reset signal RST of logic "L" is supplied, the output of the buffer 51 is changed to the logic "H" and, therefore, the output of the inverter 52 is changed to the logic "L". This logic "L" is applied to a clear terminal CL of the flip-flop FF. Therefore, the FF is cleared and its output Q is reset to the logic "L". Then, the output Q changes in logic between "L" and "H" alternately in synchronism with a clock signal CK after the reset signal RST changes to the logic "H". During a term at the logic "H" of the signal RST, the outputs of the buffer 51 and the inverter 52 maintain the logics "L" and "H", respectively. So long as the output of the inverter 52 maintains the logic "H", the flip-flop FF cannot be cleared.

Figure 6 depicts waveforms for explaining the operation of the circuit shown in Fig. 5. Referring to both Figs. 5 and 6, the logic change of the reset signal RST is depicted in row (1) of Fig. 6, in which a time $t_1$ represents a completion of the reset operation for the flip-flop FF.

Row (2) of Fig. 6 depicts logic changes of the input/output buffer circuits (I/O) and the output buffer circuits (O) in the peripheral circuit region 22. If the output logic changes take place in both the input buffer circuits (o) and the input/output buffer circuits (I/O) all at once at a time $t_2$, the instantaneous large current flows in the $V_{ss}$ power line. This large current induces a voltage drop in the $V_{ss}$ power line. This creates a voltage rise with respect to the ground level ($V_{ss}$). The voltage rise is shown in row (3) of Fig. 6. When such a voltage rise occurs, in the $V_{ss}$ level, the logic "H" of the signal RST is seemingly lowered with respect to the rising $V_{ss}$ level. This causes a transformation of the logic "H" of the signal RST to the logic "L". Then the transformed logic "L" of the signal RST unintentionally clears the flip-flop FF. This concludes in the aforesaid malfunction. According to the present invention, since the above-mentioned voltage rise is halved in level, the erroneous logic change causing the malfunction can be prevented.

The reset operation mentioned above is performed by the asynchronous reset signal. This asynchronous reset operation leads to the worst case. If a synchronous reset operation is conducted, the malfunction will not occur. This is because, under such a synchronous reset mode, it is very easy to avoid coincidence of the timing of the reset with the timing of the logic change causing the aforesaid instantaneous current flow. For example, when the reset operation is preset to be effective at every rising edge of the clock signal, the logic change causing the instantaneous large current should be preset to be effective at every falling edge thereof. However, under the asynchronous reset operation mode, it is impossible to avoid coincidence of the timings. Such coincidence may frequently occur, thus producing malfunctions.

As explained above in detail, according to the present invention, the deviation of the ground level in the semiconductor circuit, which is produced by the instantaneous large current flowing through the power lines, especially the $V_{SS}$ power line, can be suppressed. Thus, almost all malfunctions may be prevented. Particularly, the present invention is advantageous for a device having a plurality of input/output buffer cells around a basic cell array, such as a gate array LSI.

## Claims

1. A semiconductor device comprising:
a semiconductor substrate (11);
a logic circuit region (21) arranged in the semiconductor substrate, said logic circuit region having a plurality of logic circuits;
a peripheral circuit region (22) arranged around said logic circuit region, said peripheral circuit region including a plurality of output buffer circuits;
a first power line (13, 13') and a second power line (15, 15') distributed at least along the peripheral circuit region, said first power line being connected to each of said output buffer circuits; and
a sub-power line (16, 18) distributed on an insulating layer (14, 17) separating it from said first power line;
in which electric shorts are formed between said first power line and said sub-power line via through holes (33) in said insulating layer (14, 17) at each portion of said first power line under which it is connected to one of said output buffer circuits.

2. A semiconductor device as set forth in claim 1, wherein the peripheral circuit region further includes an input buffer circuit similarly connected to said first power line and said sub-power line.

3. A semiconductor device as set forth in claim 1 or claim 2, wherein said sub-power line is distributed in parallel with and right above said first power line.

4. A semiconductor device as set forth in any preceding claim, wherein both said first power line (13) and said sub-power line (16, 18) are connected to either a first power source for supplying a first power source voltage or a second power source for supplying a second power source voltage higher than the first power source voltage.

5. A semiconductor device as set forth in any preceding claim, wherein the first power source is connected to the first power line (13), the second power source is connected to the second power line (15), the first power line is formed on a first insulating layer (12), and the sub-power line (16) and the second power line are formed on a second insulating layer (14).

6. A semiconductor device as set forth in any of the claims 1—4, wherein the second power line (15') is formed on a first insulating layer (12), the first power line (13') is formed on a second insulating layer (14), and the sub-power line (18) is formed on a third insulating layer (17).

7. A semiconductor device as set forth in claim 6, wherein said sub-power line is wide enough to cover both the first and second power lines.

8. A semiconductor device as set forth in any preceding claim, wherein the first power line is at the ground potential.

## Patentansprüche

1. Halbleitervorrichtung mit:
einem Halbleitersubstrat (11);
einem Logikschaltungsbereich (21), der in dem Halbleitersubstrat angeordnet ist und der eine Vielzahl von logischen Schaltungen hat;
einem peripheren Bereich (22), der um den genannten Logikschaltungsbereich angeordnet ist und der eine Vielzahl von Ausgangspufferschaltungen umfaßt;
einer ersten Energieleitung (13, 13') und einer zweiten Energieleitung (15, 15'), die wenigstens längs dem peripheren Schaltungsbereich verteilt sind, wobei die erste Energieleitung mit jeder der genannten Ausgangspufferschaltungen verbunden ist; und
einer sub-Energieleitung (16, 18), die auf einer isolierenden Schicht (14, 17) verteilt ist, welche sie von der genannten ersten Energieleitung trennt; bei welcher elektrische Kurzschlüsse zwischen der genannten ersten Energieleitung und der genannten sub-Energieleitung über Durchgangslöcher (33) in der genannten isolierenden Schicht (14, 17) bei jedem Abschnitt der genannten ersten Energieleitung gebildet sind, unter welchem sie mit einer der genannten Ausgangspufferschaltungen verbunden ist.

2. Halbleitervorrichtung nach Anspruch 1, bei der der periphere Schaltungsbereich ferner eine Eingangspufferschaltung umfaßt, die in ähnlicher Weise mit der genannten ersten Energieleitung und der genannten sub-Energieleitung verbunden ist.

3. Halbleitervorrichtung nach Anspruch 1 oder 2, bei der die genannte sub-Energieleitung parallel zu und direkt über der ersten Energieleitung verteilt ist.

4. Halbleitervorrichtung nach einem der vorhergehenden Ansprüche, bei der sowohl die erste Energieleitung (13) als auch die genannte sub-Energieleitung (16, 18) entweder mit einer ersten Energiequelle verbunden sind, um eine erste Energiequellenspannung zu liefern, oder einer zweiten Energiquelle, um eine zweite Energiequellenspannung zu liefern, die höher als die erste Energiequellenspannung ist.

5. Halbleitervorrichtung nach einem der vorhergehenden Ansprüche, bei der die genannte erste Energiequelle mit der ersten Energieleitung (13) verbunden ist, die zweite Energiequelle mit der zweiten Energieleitung (15) verbunden ist, die erste Energieleitung auf einer ersten isolierenden Schicht (12) gebildet ist, und die sub-Energieleitung (16) und die zweite Energieleitung auf einer zweiten isolierenden Schicht (14) gebildet sind.

6. Halbleitervorrichtung nach einem der Ansprüche 1 bis 4, bei der die zweite Energieleitung (15') auf einer ersten isolierenden Schicht (12), die erste Energieleitung (13) auf einer zweiten isolierenden Schicht (14) und die sub-Energieleitung (18) auf der dritten isolierenden Schicht (17) gebildet sind.

7. Halbleitervorrichtung nach Anspruch 6, bei der die sub-Energieleitung breit genug ist, um sowohl die erste als auch die zweite Energieleitung zu bedecken.

8. Halbleitervorrichtung nach einem der vorhergehenden Ansprüche, bei der die erste Energieleitung auf Erdpotential ist.

**Revendications**

1. Composant à semi-conducteurs comportant:
un substrat semi-conducteur (11);
une région (21) de circuits logiques disposée dans le substrat semi-conducteur, ladite région de circuits logiques comprenant plusieurs circuits logiques;
une région (22) de circuits périphériques disposée autour de la région des circuits logiques, cette région de circuits périphériques comprenant plusieurs circuits tampon de sortie;
une première ligne d'alimentation (13, 13') et une deuxième ligne d'alimentation (15, 15') distribuées au moins le long de la région de circuits périphériques, la première ligne d'alimentation étant connectée à chacun desdits circuits tampon de sortie; et
une ligne de sous-alimentation (16, 18) distribuée sur une couche d'isolement (14, 17) qui la sépare de la première ligne d'alimentation;
dans lequel des courts-circuits électriques sont formés entre la première ligne d'alimentation et la ligne de sous-alimentation par des trous de traversée (33) dans la couche d'isolement (14, 17) à chaque partie de la première ligne d'alimentation au-dessous de laquelle est connecté l'un des circuits tampon de sortie.

2. Composant à semi-conducteurs selon la revendication 1, où la région de circuits périphériques comporte en outre un circuit tampon d'entrée connecté, de la même façon, à la première ligne d'alimentation et à la ligne de sous-alimentation.

3. Composant à semi-conducteurs selon la revendication 1 ou 2, où la ligne de sous-alimentation est distribuée parallèlement à la première ligne d'alimentation et directement au-dessus de celle-ci.

4. Composant à semi-conducteurs selon l'une quelconque des revendications précédentes, où la première ligne d'alimentation (13) et la ligne de sous-alimentation (16, 18) sont toutes deux connectées soit à une première source d'alimentation qui délivre une tension de première source d'alimentation soit à une deuxième source d'alimentation qui délivre une tension de deuxième source d'alimentation plus élevée que la tension de première source d'alimentation.

5. Composant à semi-conducteurs selon l'une quelconque des revendications précédentes, où la première source d'alimentation est connectée à la première ligne d'alimentation (13), la deuxième source d'alimentation est connectée à la deuxième ligne d'alimentation (15), la première ligne d'alimentation est formée sur une première couche d'isolement (12), et la ligne de sous-alimentation (16) et la deuxième ligne d'alimentation sont formées sur une deuxième ligne d'isolement (14).

6. Composant à semi-conducteurs selon l'une quelconque des revendications 1 à 4, où la deuxième ligne d'alimentation (15') est formée sur une première couche d'isolement (12), la première ligne d'alimentation (13') est formée sur une deuxième couche d'isolement (14), et la ligne de sous-alimentation (18) est formée sur une troisième couche d'isolement (17).

7. Composant à semi-conducteurs selon la revendication 6, où la ligne de sous-alimentation est suffisamment large pour couvrir à la fois la première et la deuxième ligne d'alimentation.

8. Composant à semi-conducteurs selon l'une quelconque des revendications précédentes, où la première ligne d'alimentation est au potentiel de la terre.

# Fig. IA

16  15

13

14
12
11

# Fig. IB

18  13′

15′

17
14
12
11

# Fig. 2

# Fig. 3

# Fig. 4 A

# Fig. 4 B

# Fig. 5

# Fig. 6

# Fig. 7